# EUROPÄISCHE PATENTSCHRIFT

(11) **EP 1 421 633 B1**
(45) Veröffentlichungstag und Bekanntmachung des Hinweises auf die Patenterteilung: **01.04.2009**
(21) Anmeldenummer: 02764558.9
(22) Anmeldetag: 27.08.2002
(51) Int. Cl.: H01L 51/05, H01L 29/786

(54) **TRANSISTORANORDNUNG UND VERFAHREN ZU DEREN HERSTELLUNG**
TRANSISTOR ASSEMBLY AND METHOD FOR THE PRODUCTION THEREOF
ENSEMBLE TRANSISTOR ET SON PROCEDE DE PRODUCTION

(30) Priorität: 27.08.2001 DE 10142913
(43) Veröffentlichungstag der Anmeldung: 26.05.2004
(73) Patentinhaber: Helmholtz-Zentrum Berlin für Materialien und Energie GmbH, 14109 Berlin (DE)
(72) Erfinder: KÖNENKAMP, Rolf, 32257 Bünde (DE); CHEN, Jie, 10589 Berlin (DE)
(74) Vertreter: Rudolph, Margit
(86) Internationale Anmeldenummer: PCT/DE2002/003191
(87) Internationale Veröffentlichungsnummer: WO 2003/026034

(56) Entgegenhaltungen:
- WO-A-02/29912
- US-A- 5 106 778
- US-A- 5 739 044
- KUDO K ET AL: "Device characteristics of lateral and vertical type organic field effect transistors" THIN SOLID FILMS, ELSEVIER-SEQUOIA S.A. LAUSANNE, CH, Bd. 393, Nr. 1-2, 1. August 2001 (2001-08-01), Seiten 362-367, XP004296481 ISSN: 0040-6090
- GARNIER F ET AL: "VERTICAL DEVICES ARCHITECTURE BY MOLDING OF ORGANIC-BASED THIN FILMTRANSISTOR" APPLIED PHYSICS LETTERS, AMERICAN INSTITUTE OF PHYSICS. NEW YORK, US, Bd. 73, Nr. 12, 21. September 1998 (1998-09-21), Seiten 1721-1723, XP000784120 ISSN: 0003-6951

## Beschreibung

Die Erfindung betrifft eine vertikale Transistoren und ein Verfahren zu deren Herstellung.

Es ist bekannt, zur Erzeugung von Dünnschichttransistoren Halbleitermaterial in planarer Anordnung auf flexible Substrate aufzubringen. Bei mechanischen Beanspruchungen der Substrate durch Biegung, Scherung oder Dehnung werden die Dünnschichttransistoren mit beansprucht, wodurch es leicht zu Verletzungen der Halbleiterschichten und Ablösungen von der Substratschicht kommt.

Der Erfindung liegt die Aufgabe zugrunde, vertikale Transistoren und ein Verfahren zu deren Herstellung anzugeben, wobei ein flexibles Substrat verwendet werden soll, dessen mechanische Beanspruchung jedoch nicht zu Beeinträchtigungen der Funktion der Transistoren führt.

Erfindungsgemäß wird die Aufgabe gelöst durch die Merkmale der Ansprüche 1 und 8: Zweckmäßige Ausgestaltungen sind Gegenstand der Unteransprüche.

Danach sind die vertikale Transistoren so aufgebaut, dass in Mikrolöchern durch einen Folienverbund, bestehend aus zwei Kunststofffolien mit zwischenliegender Metallschicht, vertikal Halbleitermaterial eingebracht ist, welches durch Metallisierung der Ober- und Unterseite des Folienverbunde mit Kontakten versehen ist.

Als Mikrolöcher werden nach der Erfindung zylindrische Ionenspurkanäle genutzt, die sich durch Ionenbeschuss und nachfolgende Ätzbehandlung in Polymer- oder Polyesterfolien ausbilden. Diese Ionenspurkanäle können mit Elektrodeposition, chemischer Badabscheidung oder anderen geeigneten Verfahren mit Verbindungshalbleitem oder zunächst mit einer hohlzylindrischen Isolatorschicht und anschließend mit einem Verbindungshalbleiter aufgefüllt werden.

Der Folienverbund, in den das Halbleitermaterial eingebettet wird, wird hergestellt, indem eine Folie, z. B. durch Bedampfen, mit einer Metallschicht versehen wird und eine zweite Folie mittels Haftvermittler auf die Metallschichtseite der ersten Folie aufgeklebt wird. Anschließend erfolgt der Ionenbeschuss in einem Beschleuniger. Mit dem Ionenbeschuss bilden sich entlang der Ionenspur amorphe Kanäle in der Folie mit einem Durchmesser von wenigen Angström aus. Die erzeugten Ionenspurkanäle sind darauf sensitiviert für eine nachfolgende Ätzbehandlung, mit der sich Mikrolöcher in den Kunststofffolien bilden. Gegebenenfalls erfolgt vor der Ätzbehandlung noch eine weitere Sensitivierung mit einem chemischen Sensitivator. Das Verfahren zur Bildung von Mikrolöchem in Folien, allerdings mit einer einlagigen Folie und ohne die zwischen die Folienlagen eingebrachte Metallschicht, wird bisher zur Herstellung von Mikrofiltern und anderen Anwendungen genutzt, nicht jedoch für Transistoren.

Nach dem Ätzen der beidseitig angebrachten Polymerfolien, entfernt man die Metallfolie im Lochbereich durch einen weiteren Ätzvorgang. Die Metallschicht kann dabei gerade so weit entfernt werden, dass sie noch bis an den lonenspurkanal in den Folien heranreicht. Die mittige Metallschicht dient in dem vorgeschlagenen Transistor als Gate-Kontakt und sollte deshalb zu dem Halbleitermaterial entweder einen Schottky-Kontakt bilden (MESFET) oder bezüglich des Halbleiters isoliert sein (MOSFET), wie das z. B. in S. M. Sze, Physics of Semiconductor Devices. Wiley, New York, 1981, S. 312 ff. u. S. 431 ff. gezeigt ist. Wenn die Materialkombination Metall/Halbleiter es zulässt, kann man zur Bildung eines MESFET Halbleitermaterial in Elektrodeposition vom Rand der mittigen Metallschicht aus aufwachsen, sodass sich ein Schottky-Kontakt ausbildet.

Zur Herstellung eines MOSFET wird zunächst, z. B. mittels Badabscheidung, eine Isolierschicht an der Innenwandung des gesamten Kanals aufgewachsen. Eine Isolierschicht kann auch nur im Bereich der Metallschicht gebildet werden, indem diese von den Mikrolöchem aus chemisch oder elektrochemisch umgewandelt, z.B. oxidiert, wird. Eine Alternative zu einer Isolierschicht ist das Wegätzen der Metallschicht rings um das Mikroloch herum, sodass sich ein isolierender Hohlraum bildet.

Nachdem die Mikrolöcher aus den Ionenspurkanälen vollständig ausgebildet sind, erfolgt das Einbringen des Halbleitermaterials mittels Elektrodeposition oder chemischer Badabscheidung. Durch anschließendes Metallisieren der Ober- und Unterseite des Folienverbundes werden Source- und Drain-Kontakte gebildet. Gegebenenfalls muss bereits vor der Elektrodeposition mindestens eine Seite des Folienverbundes metallisiert werden, um eine Elektrode für die Anlage eines Potentials bei der Elektrodeposition zu haben. Dabei lassen sich durch Strukturierung der Metallisierungsschicht mittels üblicher lithographischer Verfahren, z. B. in Matrixform, Transistoren jeweils zu Transistorverbänden zusammenfassen, die dann gemeinsam angesteuert werden können. Unterstützt werden kann die Bildung von bereichsweisen Transistoranordnungen dadurch, dass der Folienverbund auch bereits vor dem Ionenbeschuss maskiert wird. Letztlich lassen sich auch einzelne Transistoren an einem vorbestimmten Ort herstellen, indem der Folienverbund zur Bildung von einzelnen Ionenspurkanälen mit einem gesteuerten Ionenstrahl beschossen wird.

Die zylindrische, vertikale Anordnung der Transistoren hat den Vorteil, dass sie mechanisch sehr robust ist, da die Folie biegbar oder dehnbar ist. Das organische Folienmaterial ist zudem wesentlich weicher als das anorganische Transistormaterial. Dadurch werden auftretende Biege-, Scher- und Druckkräfte fast glanz vom Folienmaterial aufgenommen, so dass die Transistorkennlinie und andere elektrische Parameter weitgehend konstant unter Biege-, Flex- und Zugkräften sind.

Da die Mikrolöcher bis hinunter zu 30 nm Durchmesser hergestellt und mit Halbleitermaterial aufgefüllt werden können, lassen sich Transistoren im Nanometer-Maßstab auch ohne Lithographie und ohne Maskentechnik herstellen. Die Channel-Länge des Transistors ist durch den Raumladungsbereich des mittigen Gate-Kontaktes gegeben. Im allgemeinen ist dieser wesentlich kleiner als Dicke der Folien, die den Source-Drain-Abstand bestimmt, sodass der Transistor am besten im "Verarmungsmodus" betrieben wird, siehe DE-C 199 16 403. Aufgrund des kleinen Duchmessers und der kleinen Channel-Länge ergeben sich Möglichkeiten, den Transistor im Quanten-Regime zu betreiben.

Durch die möglichen sehr kleinen Abmessungen ergeben sich auch für die Integration in Schaltkreisen Vorteile.

Die Anwendungen sind vielfältig. Für Anwendungen im Display-Bereich kommt z. B. eine Folie in DIN A 4-Größe mit nahe beieinanderliegenden vertikalen Transistoren in Frage, die zu optischen Pixeln mit etwa 1000 Transistoren geordnet werden. Die Transistoren sind zwar unregelmäßig verteilt, durch die hohe Anzahl der Transistoren/Pixel kann dennoch eine exakte Ansteuerung der Pixel erfolgen. Bei einem Durchmesser der Transistoren von 150 nm und einem durchschnittlichen Abstand von 500 nm ergibt sich für 1000 Transistoren beispielsweise eine Pixelgröße von etwa 20x20 µm², d.h. eine durchaus gängige Größe.

Die Erfindung soll nachstehend anhand von Ausführungsbeispielen näher erläutert werden. In den zugehörigen Zeichnungen zeigen
- Fig. 1: einen erfindungsgemäßen Transistor im Schnitt,
- Fig. 2: eine zweite Variante eines Transistors im Schnitt und
- Fig. 3: die Energiebandlücke eines erfindungsgemäßen Transistors.

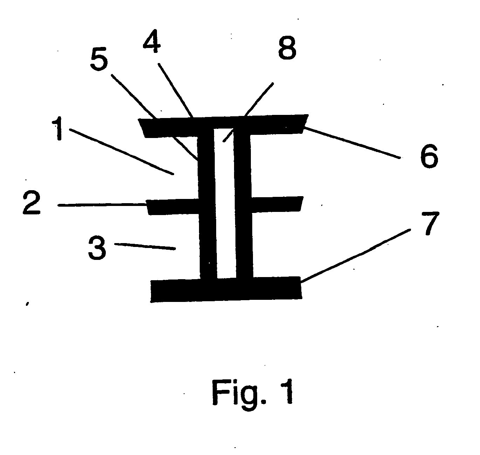

Das Herstellungsverfahren soll anhand der Schnittdarstellung eines einzelnen Transistors in Fig. 1 erläutert werden. Zunächst wird eine ca. 5 µm dicke PET-Folie 1 (Polyethyleneterephthalat) einseitig mit einer Metallschicht 2 (z.B. Al, Cu, Ag) bedampft. Mittels eines Haftvermittlers wird die metallische Seite anschließend mit einer zweiten 5 µm dicken PET-Folie 3 zu einem Folienverbund verklebt.

Etwa DIN A 4 große Abschnitte werden zur Bildung von Ionenspurkanälen in einem Beschleuniger mit schnellen Ionen beschossen, vorzugsweise mit Krypton- oder Xenonionen mit einer Energie von einigen 100 MeV bei einer Dichte von etwa 10⁸/cm². Die entstandenen Ionenspurkanäle werden anschließend mit einem Sensitivator (z.B. Dimethylformamid, Pyridin, Dioxan) vorbehandelt und dann in Natronlauge (NaOH) geätzt. Je nach Ätzzeit entstehen so Mikrolöcher 4 mit einem Durchmesser zwischen 30 nm und 20 µm. Anschließend wird die mittige Metallschicht geätzt (im Fall von Al z.B. ebenfalls mit Natronlage, im Fall von Cu mit HNO₃, etc.). Durch chemische Badabscheidung oder ein anderes Verfahren, wie in DE-C 199 16 403 gezeigt ist, werden darauf die Mikrolöcher **4** mit einer Isolierschicht **5** aus TiO₂ oder einem anderen Oxid ausgekleidet.

Anschließend erfolgt elektrochemisch das Einwachsen von p-leitendem Kupferthiocyanat 8 (CuSCN) in die Mikrolöcher 4, wobei sich die Dotierung durch Einstellen der Potentialverhältnisse verändern lässt, siehe auch C. Rost et al., Appl. Phys. Lett. 75, 692 (1999). Hierzu wird zunächst eine Seite des Folienverbundes für eine Potentialanlage mit einer Gold-Metallschicht versehen, die später einen Source-Kontakt 6 oder einen Drain-Kontakt 7 bildet. Die Elektrodeposition kann in einem normalen Potentiostaten erfolgen, wobei sich eine 0,05 molare Cu(BF₄)₂-Lösung und 0,025 molares KSCN in Äthanol bei kathodischer Spannung von -(0,2 bis 0,8) V gegen eine Platin-Referenzelektrode als praktikabel erwiesen hat. Es hat sich gezeigt, dass die Bildung hexagonaler Kristalle mit <001 >- oder <101>-Ausrichtung möglich ist.

Nach dem vollständigen Füllen der Mikrolöcher 4 mit CuSCN wird durch Bedampfen der zweiten Seite des Folienverbundes mit Platin ein Source-Kontakt 6 bzw. ein Drain-Kontakt 7 hergestellt. Die mittlere Metallschicht 2 bildet den Gate-kontakt.

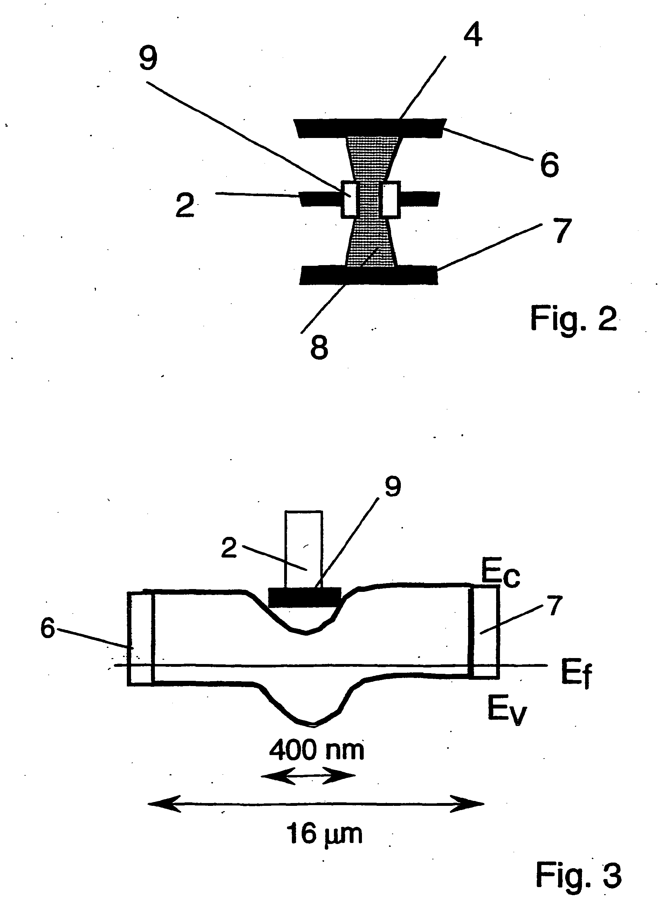

Eine weitere Möglichkeit zeigt Fig. 2. Durch den Ätzfortschritt entstehen nach außen etwas keglig aufgeweitete Mikrolöcher 4, die im Gate-Bereich einen Durchmesser von ca. 100 nm haben. Die Metallschicht 2 besteht aus Aluminium. Sie wird an ihrem Rand an den herausgeätzten Mikrolöchem 4 elektrochemisch zu Aluminiumdioxid 9 oxidiert, sodass in diesem Fall keine Isolierschicht eingebracht werden muss.

In Fig. 3 sind die Energieverhältnisse der Elektronenteitung an einem solchen Transistor dargestellt. Das Gate verursacht eine Raumladungszone von etwa 400 nm Länge, in der sich das Potential des CuSCN verschieben lässt. Da das CuSCN p-leitend ist, erfolgt bei positivem Gate-Potential Verarmung im Channel. Wenn die Verarmung durch die gesamte Dicke des Halbleiterzylinders hindurchreicht, tritt eine starke Verringerung der Leitfähigkeit zwischen Source und Drain ein. Bei negativem Gate-Potential erfolgt Anreicherung im Channel. Da die Channel-Länge aber gering gegenüber dem Source-Drain Abstand ist, bleibt die Leitfähigkeitserhöhung zwischen Source und Drain gering.

## Patentansprüche

1. Vertikale Transistoren
**dadurch gekennzeichnet, dass**
in Mikrolöchem (4) durch einen Folienverbund, bestehend aus zwei Kunststofffolien (1, 3) mit zwischenliegender Metallschicht (2), Halbleitermaterial (8) eingebracht ist, welches durch Metallisierung der Ober- und Unterseite des Folienverbundes mit Kontakten (6, 7) versehen ist.

2. Vertikale Transistoren nach Anspruch 1,
**dadurch gekennzeichnet, dass**
die Folien (1, 3) Polymerfolien sind.

3. Vertikale Transistoren nach Anspruch 1,
**dadurch gekennzeichnet, dass**
die Folien (1, 3) Polyesterfolien sind.

4. Vertikale Transistoren nach Anspruch 3,
**dadurch gekennzeichnet, dass**
die Folien (1, 3) PET-Folien sind.

5. Vertikale Transistoren nach einem der vorhergehenden Ansprüche,
**dadurch gekennzeichnet, dass**
die Folien (1, 3) eine Dicke von 2 µm bis 30 µm aufweisen.

6. Vertikale Transistoren nach einem der vorhergehenden Ansprüche,
**dadurch gekennzeichnet, dass**
die Metallschicht (2) aus Kupfer, Aluminium oder Silber besteht.

7. Vertikale Transistoren nach einem der vorhergehenden Ansprüche,
**dadurch gekennzeichnet, dass**
das Halbleitermaterial Kupferthiocyanat (CuSCN) (8) ist.

8. Verfahren zur Herstellung vertikalen Transistoren,
**dadurch gekennzeichnet, dass**
eine Metallschicht (2) zwischen zwei Kunststofffolien (1,3) eingebettet wird, in diesen Folienverbund mittels Ionenbeschuss Ionenspurkanäle eingebracht werden, der Folienverbund nachfolgend einer Ätzbehandlung unterzogen wird, wobei durch das Merausärgen der Ionenspurkanäle mikrolöcher (4) durch den Folienverbund entstehen, die Mikrolöcher mit Halbleitermaterial (8) aufgefüllt werden und durch Metallbeschichtung (6,7) auf der Ober- und Unterseite des Folienverbundes Source/Drain-Kontakte erzeugt werden.

9. Verfahren nach Anspruch 8,
**dadurch gekennzeichnet, dass**
die Metallschicht zwischen den Kunststofffolien innerhalb der Mikrolöcher einer gesonderten Ätzbehandlung unterzogen wird.

10. Verfahren nach Anspruch 8 oder 9,
**dadurch gekennzeichnet, dass**
die Mikrolöcher zur Bildung von Feldeffekttransistoren mit einer Isolierschicht versehen werden.

11. Verfahren nach Anspruch 8 oder 9
**dadurch gekennzeichnet, dass**
die Metallschicht zur Bildung von Feldeffekttransistoren im Bereich der Mikrolöcher bis hinter den Durchmesser der Mikrolöcher weggeätzt wird.

12. Verfahren nach Anspruch 8 oder 9,
**dadurch gekennzeichnet, dass**
die Metallschicht zur Bildung von Feldeffekttransistoren im Bereich der Mikrolöcher elektrochemisch oxidiert wird.

13. Verfahren nach einem der Ansprüche 8 bis 12,
**dadurch gekennzeichnet, dass**
das Auffüllen der Mikrolöcher mit Halbleitermaterial mittels Elektrodeposition erfolgt.

14. Verfahren nach einem der Ansprüche 8 bis 12,
**dadurch gekennzeichnet, dass**
das Auffüllen der Mikrolöcher mit Halbleitermaterial mittels chemischer Badabscheidung erfolgt.

15. Verfahren nach einem der Ansprüche 8 bis 14,
**dadurch gekennzeichnet, dass**
mit der Ätzbehandlung der Ionenspurkanäle Mikrolöcher mit einem Durchmesser zwischen 30 nm und 20 µm gebildet werden.

16. Verfahren nach einem der Ansprüche 8 bis 15,
**dadurch gekennzeichnet, dass**
die Metallschicht auf eine Seite einer Kunststofffolie durch Verdampfen oder Sputtern aufgebracht wird.

17. Verfahren nach dem Anspruch 16,
**dadurch gekennzeichnet, dass**
die mit der Metallschicht versehene Kunststofffolie und eine zweite Kunststofffolie miteinander verklebt werden.

18. Verfahren nach einem der Ansprüche 8 bis 17,
**dadurch gekennzeichnet, dass**
das Ätzen der Ionenspurkanäle mit Natronlauge erfolgt.

19. Verfahren nach einem der Ansprüche 8 bis 18,
**dadurch gekennzeichnet, dass**
beim Ionenbeschuss mit einer Ionendichte von 10⁷ bis 10⁹/cm² gearbeitet wird.

20. Verfahren nach einem der Ansprüche 8 bis 19,
**dadurch gekennzeichnet, dass**
beim Ionenbeschuss mit einer Energie von mehreren 100 MeV gearbeitet wird.

21. Verfahren nach einem der Ansprüche 8 bis 20,
**dadurch gekennzeichnet, dass**
der Folienverbund vor dem Ätzen der Ionenspurkanäle mit einem Sensitivator behandelt wird.

22. Verfahren nach einem der Ansprüche 8 bis 21,
**dadurch gekennzeichnet, dass**
der Folienverbund vor der Metallbeschichtung seiner Ober- und Unterseite maskiert wird.

23. Verfahren nach einem der Ansprüche 8 bis 22,
**dadurch gekennzeichnet, dass**
der Folienverbund vor dem Ionenbeschuss maskiert wird.

## Claims

1. Vertical transistors,
**characterised in that**
semiconductor material (8) is introduced into micro holes (4) through laminated film consisting of two plastic films (1, 3) with an intermediate metal layer (2), the semiconductor material (8) is provided with contacts (6, 7) by metallization of the upper and lower surface of the laminated film.

2. Vertical transistors according to claim 1,
**characterised in that** the films (1, 3) are polymer films.

3. Vertical transistors according to claim 1,
**characterised in that** the films (1, 3) are polyester films.

4. Vertical transistors according to claim 3,
**characterised in that** the films (1, 3) are PET films.

5. Vertical transistors according to one of the preceding claims,
**characterised in that** the films (1, 3) are of a thickness in the range of 2 µm to 30 µm.

6. Vertical transistors according to one of the preceding claims,
**characterised in that** the metal layer (2) consists of copper, aluminium or silver.

7. Vertical transistors according to one of the preceding claims,
**characterised in that** the semiconductor material is copper thiocyanate (CuSCN) (8).

8. Method of fabricating vertical transistors,
**characterised in that** a metal layer (2) is embedded between two plastic films (1, 3), ion track channels are introduced into this laminated film by ion bombardment, the laminated film is subsequently subjected to an etching treatment, whereas due to the etching treatment of ion trace channels micro holes (4) are generated through the laminated film, the micro holes (4) are filled with semiconductor material (8) and source/drain contacts are formed on the upper and lower surface of the laminated film by metal coating (6, 7).

9. Method according to claim 8,
**characterised in that** the metal layer between the plastic films is etched within the micro holes by a special etching treatment.

10. Method according to claim 8 or 9,
**characterised in that** the micro holes are provided with an insulating layer to form field effect transistors.

11. Method according to claim 8 or 9,
**characterised in that** the metal layer in the area of the micro holes is under-etched compared to the diameter of the micro holes to form field effect transistors.

12. Method according to claim 8 or 9,
**characterised in that** the metal layer in the area of the micro holes is electrochemically oxidized to form field effect transistors.

13. Method according to one of claims 8 to 12,
**characterised in that** filling of the micro holes with semiconductor material is carried out by electrodeposition.

14. Method according to one of claims 8 to 12,
**characterised in that** filling of the micro holes with semiconductor material is carried out by chemical bath deposition.

15. Method according to one of claims 8 to 14,
**characterised in that** the etching treatment of the ion track channels results in the formation of micro holes of a diameter between 30 nm and 20 µm.

16. Method according to one of claims 8 to 15,
**characterised in that** the metal layer is provided to one surface of a plastic film by vapour deposition or sputtering.

17. Method according to claim 16,
**characterised in that** the plastic film provided with the metal layer and a second plastic film are adhesively connected to each other.

18. Method according to one of claims 8 to 17,
**characterised in that** the etching of the ion track channels is carried out with a sodium hydroxide solution.

19. Method according to one of claims 8 to 18,
**characterised in that** the ion bombardment is carried out at an ion density of 10⁷/cm² to 10⁹/cm².

20. Method according to one of claims 8 to 19,
**characterised in that** the ion bombardment is carried out at an energy of several 100 MeV.

21. Method according to one of claims 8 to 20,
**characterised in that** the laminated film is treated with a sensitizing agent prior to etching of the ion track channels.

22. Method of one of claims 8 to 21,
**characterised in that** the laminated film is masked prior to metal coating of its upper and lower surface.

23. Method according to one of claims 8 to 22,
**characterised in that** the laminated film is masked prior to ion bombardment.

## Revendications

1. Transistors verticaux
**caractérisés en ce que**
dans des microtrous (4) réalisés dans une combinaison de films, composée de deux films de matière plastique (1, 3) avec interposition d'une couche métallique (2), on introduit une matière semi-conductrice (8) munie de contacts (6, 7) par métallisation de la surface supérieure et de la surface inférieure de la combinaison de films.

2. Transistors verticaux selon la revendication 1,
**caractérisés en ce que**
les films (1, 3) sont des films de polymères.

3. Transistors verticaux selon la revendication 1,
**caractérisés en ce que**
les films (1, 3) sont des films de polyester.

4. Transistors verticaux selon la revendication 3,
**caractérisés en ce que**
les films (1, 3) sont des films de PET.

5. Transistors verticaux selon l'une des revendications précédentes,
**caractérisés en ce que**
les films (1, 3) ont une épaisseur comprise entre 2 µm jusqu'à 30 µm.

6. Transistors verticaux selon l'une des revendications précédentes,
**caractérisés en ce que**
la couche métallique (2) est en cuivre, aluminium ou argent.

7. Transistors verticaux selon l'une des revendications précédentes,
**caractérisés en ce que**
la matière semi-conductrice est du thiocyanate de cuivre (CuSCN) (8).

8. Procédé de fabrication de transistors verticaux,
**caractérisé en ce qu'**
on intègre une couche métallique (2) entre deux films de matière plastique (1, 3), et dans cette combinaison de films on réalise des canaux de traces d'ions par un tir ionique,
puis on soumet la combinaison de films à un traitement de gravure, le dégagement par gravure des canaux sollicités par les ions comportant des microtrous (4) formant la combinaison des films, les microtrous étant remplis d'une matière semi-conductrice (8) et le revêtement métallique (6, 7) est formé sur la face supérieure et la face inférieure de la combinaison de films pour générer les contacts source-drain.

9. Procédé selon la revendication 8,
**caractérisé en ce que**
la couche métallique entre les films de matière plastique dans les microtrous est soumise à une opération de gravure particulière.

10. Procédé selon la revendication 8 ou 9,
**caractérisé en ce qu'**
on munit les microtrous d'une couche d'isolation pour former des transistors à effet de champ.

11. Procédé selon les revendications 8 ou 9,
**caractérisé en ce que**
pour former les transistors à effet de champ, on dégage la couche métallique au niveau des microtrous jusque derrière le diamètre des microtrous.

12. Procédé selon les revendications 8 ou 9,
**caractérisé en ce qu'**
on oxyde la couche métallique pour former des transistors à effet de champ dans la zone des microtrous.

13. Procédé selon l'une des revendications 8 à 12,
**caractérisé en ce qu'**
on remplit les microtrous avec une matière semi-conductrice par dépôt électrolytique.

14. Procédé selon l'une des revendications 8 à 12,
**caractérisé en ce qu'**
on remplit les microtrous avec des matières semi-conductrices par dépôt chimique dans un bain.

15. Procédé selon l'une des revendications 8 à 14,
**caractérisé en ce qu'**
avec un traitement par gravure des canaux de traces d'ions, on forme des microtrous ayant un diamètre compris entre 30 nm et 20 µm.

16. Procédé selon l'une des revendications 8 à 15,
**caractérisé en ce qu'**
on applique la couche métallique sur une face d'un film en matière plastique par dépôt à la vapeur ou pulvérisation.

17. Procédé selon la revendication 16,
**caractérisé en ce qu'**
on colle le film de matière plastique muni de la couche métallique et un second film de matière plastique.

18. Procédé selon l'une des revendications 8 à 17,
**caractérisé en ce qu'**
on effectue la gravure des canaux de traces ioniques par une lessive de sodium.

19. Procédé selon l'une des revendications 8 à 18,
**caractérisé en ce qu'**
on utilise un tir ionique avec une densité d'ions comprise entre 10⁷ et 10⁹/cm².

20. Procédé selon l'une des revendications 8 à 19,
**caractérisé en ce que**
le tir ionique se fait à une énergie supérieure à 100 MeV.

21. Procédé selon l'une des revendications 8 à 20,
**caractérisé en ce qu'**
avant la gravure des canaux de traces ioniques, on traite la combinaison de films avec un agent d'activation.

22. Procédé selon l'une des revendications 8 à 21,
**caractérisé en ce qu'**
avant le revêtement métallique, on masque la face supérieure et la face inférieure de la combinaison de films.

23. Procédé selon l'une des revendications 8 à 22,
**caractérisé en ce qu'**
avant le tir ionique, on masque la combinaison de films.
